# FASCICULE DE BREVET EUROPEEN

(11) **EP 3 711 307 B1**
(45) Date de publication et mention de la délivrance du brevet: **11.12.2024**
(21) Numéro de dépôt: 18816194.7
(22) Date de dépôt: 14.11.2018
(51) Int. Cl.: H04R 27/02, H04S 3/00, H04H 60/04, H04R 25/00

(54) **PROCEDE DE SONORISATION LIVE, AU CASQUE, TENANT COMPTE DES CARACTERISTIQUES DE PERCEPTION AUDITIVE DE L'AUDITEUR.**
VERFAHREN FÜR ÖFFENTLICHEN LIVE-SOUND IN EINEM KOPFHÖRER UNTER BERÜCKSICHTIGUNG DER AUDITIVEN WAHRNEHMUNGSMERKMALE DES ZUHÖRERS
METHOD FOR LIVE PUBLIC ADDRESS, IN A HEADPHONE, TAKING INTO ACCOUNT THE AUDITORY PERCEPTION CHARACTERISTICS OF THE LISTENER.

(30) Priorité: 16.11.2017 FR 1771226
(43) Date de publication de la demande: 23.09.2020
(73) Titulaire: Augmented Acoustics, 78830 Bonnelles (FR)
(72) Inventeur: SAID, Laurent, 78130 Les Mureaux (FR)
(74) Mandataire: Fédit-Loriot
(86) Numéro de dépôt international: PCT/FR2018/052838
(87) Numéro de publication internationale: WO 2019/097161

(56) Documents cités:
- WO-A1-2012/066149
- WO-A1-2016/172111
- US-A1- 2008 069 385
- US-A1- 2017 017 461

## Description

L'invention a trait au domaine de la sonorisation. Plus précisément, l'invention concerne un procédé et un système de sonorisation permettant de diffuser en live (c'est-à-dire en temps réel), dans le casque d'un auditeur assistant à un concert, un signal audio conditionné à partir de canaux audios issus d'une capture sonore du concert.

Le terme « live » caractérise la simultanéité (au temps de traitement près) de la capture et de la diffusion des sons issus du concert.

Le concert peut faire l'objet d'une sonorisation générale, c'est-à-dire que les sons du spectacle sont diffusés à l'intention de l'ensemble de l'auditoire au moyen de haut-parleurs.

On connait le document US 2017/017461 A1 relatif à un mélangeur audio comprenant un récepteur audio configuré pour recevoir un signal audio comprenant une pluralité de canaux audio et un contrôleur comprenant un ou plusieurs modules configurés pour recevoir un réglage de contenu audio d'un dispositif d'interface utilisateur, ajuster les volumes relatifs des canaux audio selon le réglage de contenu audio pour fournir une pluralité de canaux audio ajustés et combiner les canaux audio ajustés pour générer un contenu audio personnalisé.

On connaît de la demande internationale PCT WO 2016/124865 (Augmented Acoustics) une technique de sonorisation d'un spectacle permettant de diffuser, dans le casque d'un auditeur assistant au spectacle, un signal restituant des sons enregistrés en live, en lui permettant d'effectuer lui-même un mixage de différentes pistes sonores enregistrées.

Cette technique améliore considérablement l'expérience sonore de l'auditeur, car il peut lui-même adapter le niveau de chaque piste en fonction de ses préférences. Lorsque le casque est équipé d'un système de réduction du bruit ambiant, les sons issus de l'environnement sont atténués dans le casque, ce qui purifie le son perçu par l'auditeur et rend la qualité d'écoute proche de celle dont il bénéficierait dans un studio, alors même qu'il assiste au spectacle en live.

Cette technique peut encore être perfectionnée, en la rendant accessible aux personnes souffrant d'une perte auditive.

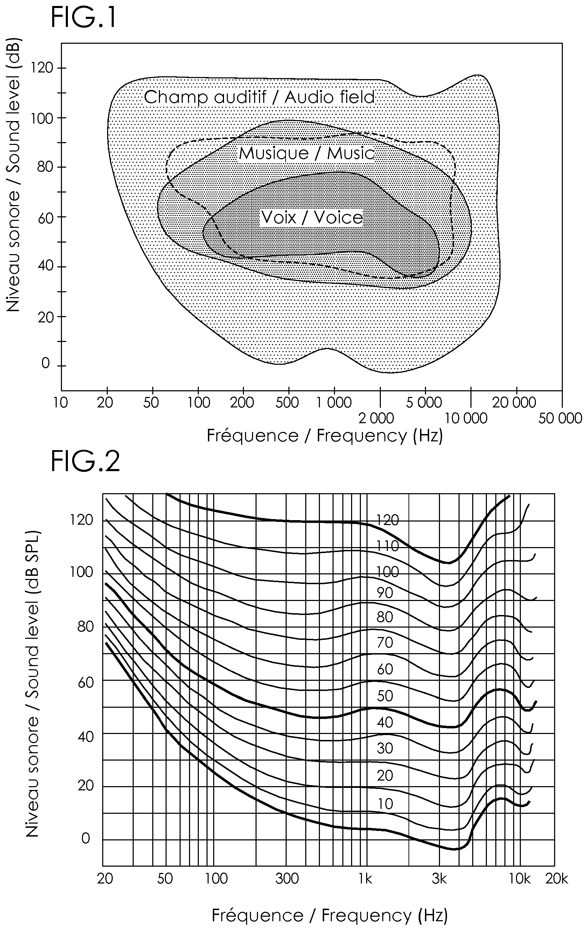

Sur le diagramme de la **FIG.1** (d'après Mercier et al, Le livre des techniques du son, T.1, Dunod, 3e éd. 2002, p.193), la zone en gris clair représente le champ auditif d'un être humain normal (c'est-à-dire ayant une parfaite perception auditive). La limite inférieure du champ auditif est le seuil de perception. Sa limite supérieure est le seuil de
douleur. Superposé au champ auditif, on a représenté (en gris moyen) le champ musical (« Musique »), c'est-à-dire le champ acoustique dans lequel vibrent habituellement les instruments de musique. Comme les instruments de musique ont été conçus pour être perçus par l'oreille humaine, il n'est pas surprenant de constater que le champ musical est strictement inclus dans le champ auditif. On a enfin représenté (en gris sombre) le champ vocal (« Voix »), c'est-à-dire le champ dans lequel vibre habituellement la voix humaine, dont on voit qu'il est strictement inclus dans le champ musical.

Le diagramme de la **FIG.1** donne une approximation grossière de la perception auditive humaine. Le comportement de l'oreille en fréquence peut être modélisé de manière plus précise par des courbes isosoniques, formalisées par Fletcher et Munson dans les années 1930, perfectionnées ensuite puis standardisées par l'Organisation internationale de normalisation dans la norme ISO 226:2003.

Les courbes isosoniques de l'être humain représentent l'intensité pour laquelle toutes les fréquences de la gamme audible (de 20 Hz à 20 kHz) provoquent une sensation de niveau (appelée sonie) égale à celle du niveau d'un son de référence à 1 000 Hz (Mercier et al, op.cit., p.195).

On a représenté sur la **FIG.2** les courbes isosoniques d'un être humain normal, par incréments de 10 dB SPL (SPL : Sound Pressure Level - Niveau de pression acoustique). En gras sont représentées les courbes isosoniques correspondant :
- En bas (sous le niveau de pression acoustique de 10 dB SPL), au seuil de perception,
- Au milieu, au niveau habituel de confort (correspondant à un niveau de pression acoustique de 50 dB SPL) ;
- En haut, au seuil de douleur (niveau de pression acoustique de 120 dB SPL).

Du point de vue de la personne affectée, la perte auditive est subjective et difficilement quantifiable : la personne entend simplement mal (ou moins bien).

Cependant il est possible de mesurer la perte auditive, et ce de différentes manières.

Ainsi, sur la **FIG.1****,** on a représenté en pointillés la limite du champ auditif d'une personne souffrant d'une perte auditive : on voit que le champ auditif ainsi réduit n'englobe complètement ni le champ musical, ni le champ vocal.

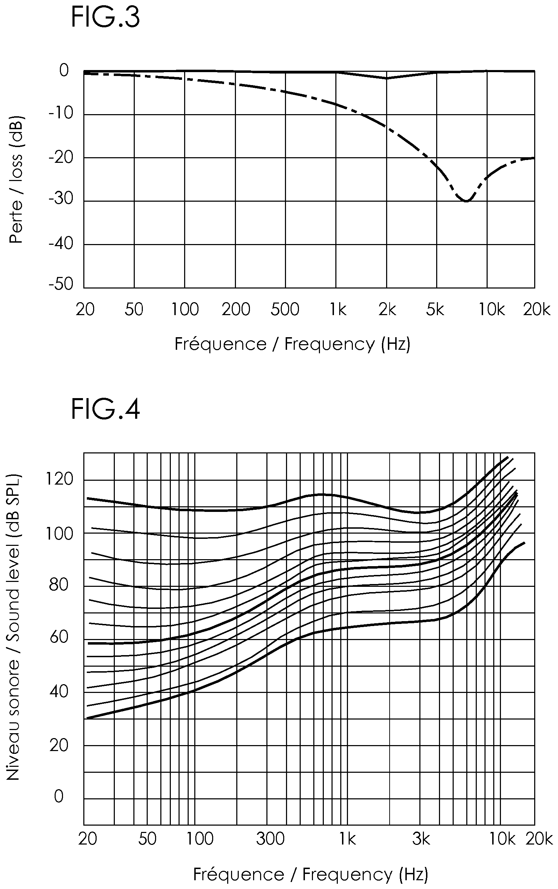

Sur la **FIG.3****,** on a représenté la perte auditive moyenne, pour l'ensemble du spectre auditif (20 Hz-20 kHz), d'une personne âgée de 50 ans (courbe en trait mixte) par comparaison à l'audition (courbe en trait continu) d'une personne normale âgée de 20 ans. (Cette courbe, qui n'est fournie qu'à titre d'exemple, illustre le phénomène de presbyacousie, c'est-à-dire de la perte auditive due à l'âge.)

Sur la **FIG.4****,** on a représenté les courbes isosoniques d'une personne affectée d'une perte auditive. Cette représentation, plus précise que celle des **FIG.1** et **FIG.3****,** n'illustre pas seulement le resserrement du champ auditif de la personne concernée : elle renseigne également sur le seuil de perception et sur le seuil de douleur, dont on voit qu'ils sont considérablement affectés dans le cas représenté.

Plus précisément, on voit que le seuil de douleur est abaissé dans les basses fréquences, tandis que le seuil de perception est relevé dans les hautes fréquences. En d'autres termes, pour l'oreille considérée sur la **FIG.4****,** les sons graves et de niveau élevé sont douloureux, tandis que les sons aigus et de faible niveau ne sont pas perçus.

En général, une personne affectée d'une perte auditive souffre avant tout des conséquences d'une mauvaise perception de la voix, dont il résulte une diminution des interactions sociales et, in fine, un certain renfermement sur soi.

C'est pourquoi les audioprothésistes se sont essentiellement concentrés sur le traitement de la voix, délaissant le traitement de la musique, considérant peut-être (à tort) qu'il s'agit d'un luxe réservé à une patientèle trop restreinte ou (à raison) que le traitement de la musique est plus complexe en raison de la plus grande amplitude - et de la plus grande richesse - du champ musical.

Or de nombreux mélomanes ayant écouté leur musique au casque à un niveau trop élevé dans les années 1970 à 1990 (avant que ne soient introduits les limiteurs de niveau sonore) sont aujourd'hui affectés de perte auditive modérée à sévère. On estime à 20% de la population les personnes touchées.

Or, si les audioprothèses sont efficaces pour rendre la voix audible (essentiellement par amplification du signal aux fréquences concernées), elles ne permettent nullement de restituer la musique d'une manière satisfaisante.

Il ne suffit d'ailleurs pas de procéder à quelques adaptations des audioprothèses pour les rendre propres au traitement de la musique, par ex. en augmentant la gamme des fréquences traitées.

En effet, comme l'indique Mercier et al (op.cit. p.50), l'oreille ne réagit pas de la même façon aux variations d'intensité dans le grave, dans le médium et dans l'aigu. Or les sons instrumentaux sont pour la plupart riches en harmoniques. La variation dynamique d'un son, par ex. un crescendo, n'est pas un simple grossissement du son comme cela est réalisé fréquemment en synthèse, mais correspond à un enrichissement du spectre dans la zone sensible de l'oreille autour de 3 000 Hz.

On aurait tort de penser qu'il suffirait de recourir aux correcteurs physiologiques bien connus des fabricants de chaînes haute-fidélité (hi-fi), qui amplifient les composantes graves et aiguës du spectre pour compenser les creux des courbes isosoniques, car ces correcteurs physiologiques sont destinés à améliorer le confort d'écoute des personnes normales, et non des malentendants, dont nous avons vu que les courbes isosoniques sont très différentes.

De fait, la pire des situations pour le malentendant est le concert, dont il ne peut maîtriser la pression acoustique autrement qu'en réglant le niveau de son audioprothèse. C'est au point qu'aujourd'hui, l'écoute de musique live est pour ainsi dire interdite aux malentendants.

L'invention vise à remédier à cela, en permettant aux personnes souffrant de perte auditive de retrouver un confort d'audition lors de l'écoute de musique diffusée en live.

A cet effet, il est proposé un procédé de sonorisation pour la diffusion en live, dans au moins un haut-parleur équipant un casque porté ou destiné à être porté par un auditeur, d'un signal audio conditionné à partir d'une pluralité de canaux audios bruts, ce procédé comprenant :
- Une phase de prétraitement comprenant les opérations consistant à :
   ∘ Prendre en compte des caractéristiques de perception auditive de l'auditeur ;
   ∘ Corriger chaque canal en fonction des caractéristiques de perception auditive de l'auditeur ;
- Une phase de mixage comprenant l'élaboration, à partir des canaux ainsi prétraités, d'un signal audio mixé ;
- Une phase de posttraitement comprenant les opérations consistant à :
   ∘ Mesurer le niveau sonore d'un bruit ambiant pénétrant dans le casque ;
   ∘ Corriger le signal audio mixé en fonction du niveau sonore du bruit ambiant ;
- Une phase de restitution, dans le casque, du signal audio conditionné issu du posttraitement ;

Dans la phase de prétraitement, la prise en compte des caractéristiques de perception auditive de l'auditeur comprend la prise en compte ou la détermination d'un niveau de confort auditif.

Aussi, dans la phase de prétraitement, la correction de chaque canal consiste-t-elle alors à le ramener sensiblement au niveau de confort auditif de l'auditeur.

Le signal audio ainsi restitué est adapté aux qualités psychoacoustiques de l'auditeur, et notamment à ses éventuelles pertes auditives. Il s'agit donc d'un signal personnalisé, susceptible non seulement de rendre audibles des domaines du spectre qui ne le seraient pas en écoute libre, mais également d'améliorer le confort d'écoute.

La correction appliquée à chaque canal comprend par ex. une correction en fréquence et/ou une correction temporelle et/ou une correction de niveau.

En pratique, la correction appliquée à chaque canal peut comprendre un ou plusieurs traitements choisis parmi un écrêtage, une compression, un gain.

Par ailleurs, la phase de prétraitement peut comprendre les opérations consistant à :
o Echantillonner chaque canal en fréquence,
o Sélectionner sur le canal une ou plusieurs gammes de fréquences ;
o Appliquer au canal un traitement dans la ou les gammes de fréquence sélectionnées, en fonction des caractéristiques de perception auditive de l'auditeur dans cette ou ces gammes de fréquence.

Il peut en outre être prévu, entre la phase de prétraitement et la phase de mixage, une opération de traitement panoramique pour constituer, à partir de chaque canal prétraité, une piste gauche et une piste droite.

Il peut également être prévu, entre le traitement panoramique et la phase de mixage, une opération d'amplification des pistes gauches et des pistes droites issues de chaque canal.

La phase de mixage est avantageusement conduite indépendamment pour les pistes gauches et pour les pistes droites, de sorte à élaborer un signal audio mixé gauche et un signal audio mixé droit.

La phase de posttraitement est alors appliquée au signal audio mixé gauche et au signal audio mixé droit pour produire un signal audio conditionné gauche et un signal audio conditionné droit.

Dans la phase de posttraitement, la mesure du niveau sonore du bruit environnant le casque peut être effectuée au moyen d'un micro intégré au casque.

De préférence, dans la phase de posttraitement :
o Un seuil de douleur pour l'auditeur est pris en compte ou déterminé ;
o Le signal audio mixé est corrigé de manière que le niveau sonore global dans le casque, comprenant le signal audio mixé et le bruit ambiant pénétrant dans le casque, soit à tout instant inférieur au seuil de douleur de l'auditeur.

Enfin, la phase de posttraitement comprend de préférence l'application d'un retard au signal audio mixé pour le recaler sur le bruit ambiant mesuré, préalablement à sa correction.

D'autres objets et avantages de l'invention apparaîtront à la lumière de la description d'un mode de réalisation, faite ci-après en référence aux dessins annexés dans lesquels :
- La **FIG.1** est un diagramme niveau-fréquence illustrant le champ auditif d'une personne normale (gris clair), le champ auditif d'une personne souffrant d'une perte auditive particulière (limite en pointillés), le champ musical (« Musique », gris moyen), et le champ vocal (« Voix », gris foncé) ;
- La **FIG.2** est un diagramme niveau-fréquence représentant les courbes isosoniques d'un être humain normal, c'est-à-dire ayant une parfaite audition ;
- La **FIG.3** est un diagramme Perte-fréquence illustrant, en trait continu, le niveau de perte acoustique (pour ainsi dire nul) d'un être humain normal, et en trait mixte le niveau de perte acoustique d'une personne souffrant de presbyacousie ;
- La **FIG.4** est un diagramme niveau-fréquence représentant les courbes isosoniques d'un être humain malentendant, souffrant d'une perte auditive particulière ;
- La **FIG.5** est un schéma montrant une scène sur laquelle est donné un concert qui fait l'objet d'une sonorisation live à destination d'un auditoire d'un système de sonorisation destiné à procurer à des malentendants présents dans l'auditoire un bon confort d'écoute du concert ;
- La **FIG.6** est un schéma illustrant en partie l'architecture fonctionnelle du système de sonorisation ;
- Les **FIG.7, FIG.8** et **FIG.9** sont des diagrammes niveau-fréquence illustrant un même signal soumis à trois traitements différents (le signal résultant du traitement apparaît en trait mixte) : coupure (**FIG.7**)**,** compression (**FIG.8**), gain (**FIG.9**).

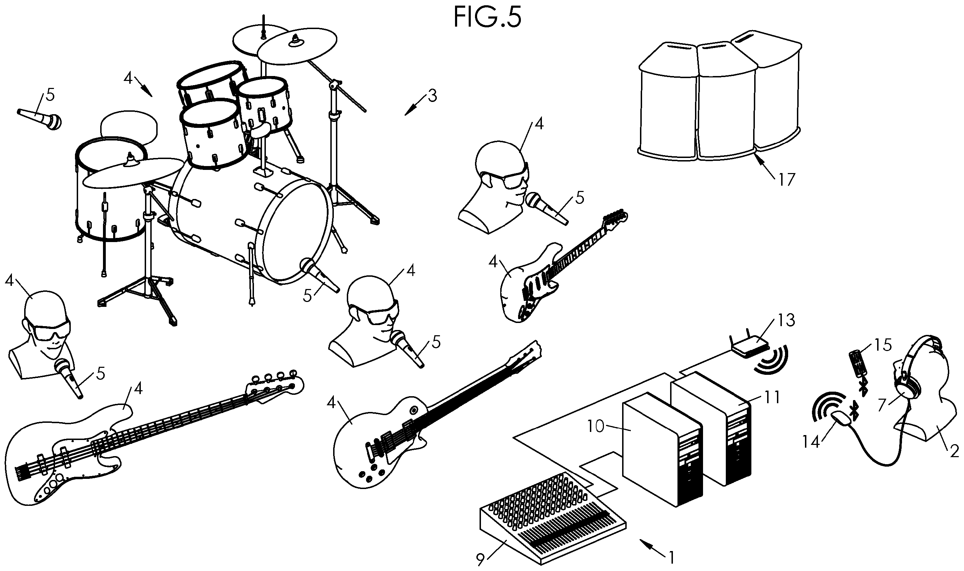

Sur la **FIG.5** est représenté un système 1 de sonorisation d'un concert émettant des sons incluant de la musique et, le cas échéant, des voix, au bénéfice d'un public (ou auditoire) comprenant un ou plusieurs auditeurs **2.** Ce concert est vivant ou « live » car les sons émis sont restitués en direct (moyennant le délai de diffusion en temps réel ou le temps de parcours du son dans l'air).

Le lieu où se déroule le concert n'est pas nécessairement fermé ; il peut notamment s'agir d'une salle, d'une esplanade, d'un plateau, d'une arène, ou encore d'un stade. Le lieu peut être abrité ou se trouver à l'air libre.

Le concert est donné par un orchestre **3** composé de sources **4** sonores comprenant des instruments (joués par des musiciens instrumentistes) et, le cas échéant, des musiciens chanteurs.

Le concert bénéficie d'une prise de son, le système **1** de sonorisation comprenant à cet effet des microphones **5** pointant chacun vers une ou plusieurs sources **4** sonores (instruments ou groupes d'instruments, voix ou groupes de voix). Chaque microphone **5** capture (ou enregistre) ainsi les sons issus d'une ou plusieurs sources **4** sonores sous forme d'un signal électrique formant un canal **6** audio brut. Un microphone **5** peut être fixe (en étant monté par ex. sur un pied) ou mobile, en étant par ex. tenu ou porté par un musicien chanteur ou intégré à un instrument mobile (par ex. dans une guitare basse ou dans une guitare électrique).

Chaque auditeur **2** porte (ou est destiné à porter) un casque **7** équipé d'au moins un haut-parleur **7G, 7D** (et avantageusement d'une paire de haut-parleurs **7G, 7D** dédiés respectivement à l'oreille gauche et à l'oreille droite de l'auditeur **2**).

Le système **1** de sonorisation est conçu pour diffuser en live, dans le (ou chaque) haut-parleur **7G, 7D** du casque **7,** un signal **8** audio conditionné à partir des différents canaux **6** audios bruts.

A cet effet, le système 1 de sonorisation comprend notamment une ou plusieurs console(s) **9** (intégrant chacune au moins des fonctions de mixage). La console **9** peut être équipée d'un processeur intégré susceptible d'être programmé pour appliquer des traitements du signal à chaque canal **6.**

Dans l'exemple illustré, le système **1** de sonorisation comprend un ou plusieurs serveurs **10, 11** relié(s) à la console **9,** et incluant des processeurs programmés pour appliquer des traitements du signal à chaque canal **6.**

La console **9** est configurée pour recueillir parallèlement plusieurs pistes **12** issues des différents canaux **6,** ou les canaux **6** eux-mêmes. Les canaux **6** sont par ex. au nombre de huit, mais ce nombre n'est pas limitatif.

Selon un mode de réalisation illustré sur la **FIG.5****,** le système **1** de sonorisation comprend un serveur **10** d'applications, qui intègre des fonctions de traitement du signal, et un serveur **11** de communication. Le serveur **11** de communication est relié à (et gère) un ou plusieurs routeurs **13** configuré(s) pour assurer une diffusion de signaux par voie hertzienne au moyen d'une ou plusieurs antenne(s), par ex. selon la norme IEEE 802.11 (Wi-Fi).

Chaque auditeur **2** est équipé d'un appareil **14** de réception et de lecture des signaux reçus de la console **9** ou du serveur **11** de communication via au moins un routeur **13.** Cet appareil **14** est directement ou indirectement relié au casque **7,** soit par voie filaire (comme illustré), soit par voie hertzienne, par ex. selon la norme IEEE 802.15 (Bluetooth^{®}).

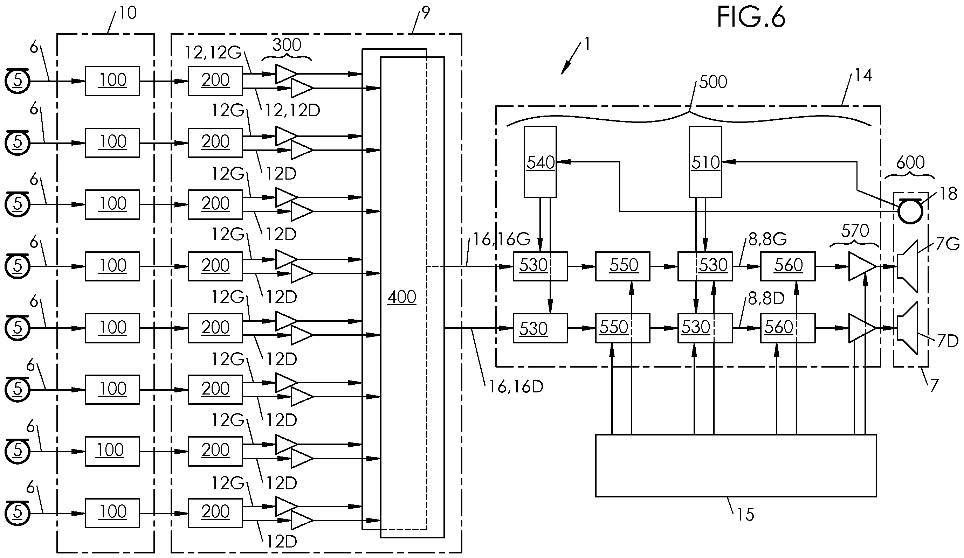

Selon un mode de réalisation illustré sur les dessins, et plus précisément sur les **FIG.5** et **FIG.6****,** le système **1** de sonorisation comprend également un terminal **15** mobile de type smartphone, tablette ou ordinateur portable. Le terminal **15** est configuré (c'est-à-dire qu'en pratique il inclut une application programmée) pour dialoguer avec l'appareil **14.**

Le terminal **15** comprend notamment un processeur, une interface primaire de communication sans fil propre à permettre le dialogue avec l'appareil **14,** par ex. selon la norme IEEE 802.15 (Bluetoothe) et une interface graphique, par ex. un écran tactile.

Le processeur du terminal **15** peut intégrer une application (qui peut être téléchargée à distance, par ex. depuis une plateforme de téléchargement ou depuis le serveur **11** de communication), comprenant des instructions pour mettre à disposition de l'auditeur **2,** via l'interface graphique, différents réglages personnalisables, par ex. une balance ou un égaliseur.

Le processeur du terminal **15** est programmé pour communiquer ces réglages à l'appareil **14** pour qu'il les applique au signal (ou aux signaux) reçu(s) de la console **9** ou du serveur **11** via le routeur **13,** avant restitution dans le(s) haut-parleur(s) **7G, 7D** du casque **7.**

Le système **1** de sonorisation est relié à, ou intègre, une base de données dans laquelle sont mémorisées des caractéristiques de perception auditive de l'auditeur **2.** Ces caractéristiques de perception auditive se présentent par ex. sous la forme de courbes isosoniques.

Selon un mode de réalisation, les caractéristiques de perception auditive de l'auditeur **2** comprennent au moins l'une des courbes suivantes :
- Une courbe représentant le seuil de perception auditive de l'auditeur **2** ;
- Une courbe représentant le seuil de douleur de l'auditeur **2** ;
- Une courbe représentant un niveau de confort acoustique de l'auditeur **2.**

Chaque courbe isosonique peut être construite lors d'une phase préalable de mesure, au cours de laquelle des stimuli sonores préenregistrés sont diffusés dans le casque **7** de l'auditeur **2** pour susciter chez lui une réponse, choisie parmi une liste à choix multiples, qui renseigne sur le niveau des stimuli tels que perçus par l'auditeur **2.**

Cette phase de mesure peut être conduite par une application implémentée dans le processeur du terminal **15,** auquel est alors raccordé le casque **7.**

Les caractéristiques de perception auditive, propre à chaque auditeur **2,** peuvent, dans ce cas, être mémorisées dans son terminal **15.** En variante, les caractéristiques de perception auditive de chaque auditeur **2** sont mémorisées sur une base de données distante, à laquelle la console **9** ou le serveur **11** de communication peut se connecter, par ex. via un identifiant (éventuellement appairé à un mot de passe) associé à l'auditeur **2** concerné.

Ces caractéristiques de perception auditives sont utilisées pour appliquer à chaque canal **6** une (ou plusieurs) correction(s) en vue d'élaborer un signal **8** audio conditionné à partir des différents canaux **6** bruts et destiné à être diffusé dans le casque **7** de l'auditeur **2,** en vue de procurer à celui-ci un bon confort d'écoute.

A cet effet, le système **1** de sonorisation est conçu pour appliquer trois phases successives.

Une première phase **100** de prétraitement comprend :
o La prise en compte des caractéristiques de perception auditive de l'auditeur **2** ;
o Une opération de correction de chaque canal **6** en fonction des caractéristiques de perception auditive de l'auditeur **2.**

Comme illustré sur la **FIG.6****,** chaque canal **6** transite à cet effet par le serveur **10** d'application (lequel peut être intégré, sous forme de module logiciel, dans la console **9**).

Chaque canal **6** se présente sous forme d'un signal électrique issu de la capture effectuée par un microphone **5.** Le canal **6** représente par conséquent le spectre audio d'une source **4** sonore particulière, laquelle, comme nous l'avons vu, peut être constituée d'un instrument ou d'un groupe d'instruments (par ex. les violons dans un orchestre symphonique) ou encore d'une ou plusieurs voix (par ex. un chanteur ou un choeur).

Le signal de chaque canal **6** peut être représenté par une courbe représentant une tension ou une puissance électrique caractéristique d'un niveau de pression acoustique (de préférence à l'échelle logarithmique), en fonction de la fréquence (qui peut également être à l'échelle logarithmique).

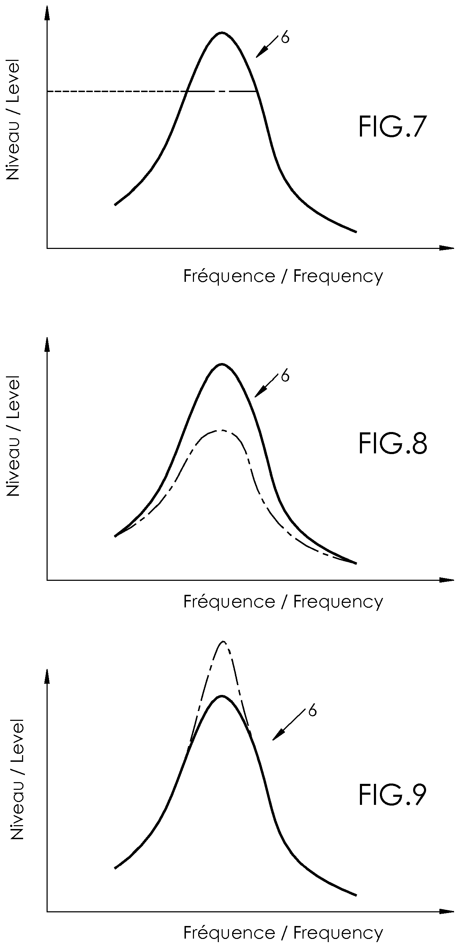

On a représenté en trait plein, sur les **FIG.7, FIG.8** et **FIG.9****,** un extrait de courbe (les échelles ne sont pas fournies) montrant une variation locale de niveau sur un canal **6.**

Plusieurs types de correction peuvent être appliqués à chaque canal **6** :
- Une correction en fréquence,
- Une correction temporelle,
- Une correction de niveau.

Chacune de ces corrections peut être appliquée seule ou en combinaison avec une ou plusieurs autres corrections.

Ainsi, la correction **100** appliquée à chaque canal **6** peut comprendre un ou plusieurs traitements choisis parmi :
- Un écrêtage (**FIG.7**), qui peut être appliqué lorsque le niveau local du signal du canal **6** dépasse un seuil correspondant (éventuellement avec une marge de sécurité) au seuil de douleur de l'auditeur **2** ou à son niveau de confort ;
- Une compression (**FIG.8**), qui peut être appliqué lorsque la pente locale du signal du canal **6** est trop verticale, ce qui indique que le niveau est susceptible de dépasser rapidement le seuil de douleur de l'auditeur **2** ou son niveau de confort ;
- Un gain (**FIG.9**), qui peut être appliqué lorsque le niveau local du signal du canal **6** est inférieur au seuil d'audition ou au niveau de confort de l'auditeur **2.**

Dans cette phase **100** de prétraitement, appliquée indépendamment à chaque canal **6,** il est avantageusement tenu compte du niveau de confort auditif de l'auditeur **2.** Si le niveau de confort n'a pas été enregistré au préalable (et stocké dans la base de données), il peut être déterminé au besoin (notamment en temps réel), par ex. par calcul à partir du seuil de douleur lorsque celui-ci est disponible.

En effet, on peut considérer que le niveau de confort d'un auditeur **2** est égal à son seuil de douleur diminué d'une atténuation donnée, par ex. d'une valeur de 10 dB.

Dans la phase **100** de prétraitement, la correction de chaque canal **6** peut consister à le ramener sensiblement (à tout le moins localement) au niveau de confort auditif de l'auditeur **2.**

En pratique, la phase **100** de prétraitement comprend par ex. les opérations consistant à :
∘ Echantillonner chaque canal en fréquence (au moyen, typiquement, d'un convertisseur analogique-numérique),
∘ Sélectionner sur le canal **6** une ou plusieurs gammes de fréquences ;
∘ Appliquer au canal **6** un traitement dans la ou les gammes de fréquence sélectionnées, en fonction des caractéristiques de perception auditive de l'auditeur **2** dans cette ou ces gammes de fréquence.

Cette séquence permet, premièrement, d'appliquer à chaque canal **6** un traitement numérique plutôt qu'un traitement analogique. Elle permet, deuxièmement, de limiter les corrections aux gammes de fréquences dans lesquelles le signal brut (échantillonné) ne saurait être diffusé tel quel vers l'auditeur **2** sans nuire à son confort d'écoute (par ex. parce que le niveau est supérieur à son niveau de confort, ou parce qu'il est inférieur à son seuil d'audition).

La phase **100** de prétraitement est suivie d'une phase **400** de mixage qui comprend l'élaboration, à partir des canaux **6** ainsi prétraités, d'un signal **16** audio mixé.

Selon un mode de réalisation illustré sur la **FIG.6****,** il est prévu, entre la phase **100** de prétraitement et la phase **400** de mixage, une opération **200** de traitement panoramique pour constituer, à partir de chaque canal **6** prétraité, une piste **12G** gauche et une piste **12G** droite. Le traitement **200** panoramique peut être appliqué par la console **9** ou par le serveur **10** d'application.

Dans ce cas, la **400** phase de mixage est avantageusement conduite indépendamment pour les pistes **12G** gauches et pour les pistes **12D** droites issues du prétraitement de chaque canal **6,** de sorte à élaborer un signal **16G** audio mixé gauche et un signal **16D** audio mixé droit en sortie de la console **9.**

Comme illustré également sur la **FIG.6****,** il peut en outre être prévu, entre le traitement **200** panoramique et la phase **400** de mixage, une opération **300** d'amplification des pistes **12G** gauches et des pistes **12D** droites issues de chaque canal **6.** Cette amplification **300** peut être appliquée par la console **9** ou par le serveur **10** d'application.

Comme chaque canal **6** a été corrigé pour tenir compte, dans des parties spécifiques de son spectre, des caractéristiques de perception auditive de l'auditeur **2,** le signal **16** audio mixé (éventuellement séparé gauche-droite) est, sur l'ensemble du spectre, adapté à cette perception auditive. En particulier, le signal **16** audio mixé peut être adapté au niveau de confort auditif de l'auditeur **2.**

Cependant le concert est diffusé en live. Il génère par conséquent des sons naturels qui se propagent en champ libre. En outre, le concert peut faire l'objet (au moyen du système **1** de sonorisation ou d'un système séparé) d'une sonorisation générale à destination de l'audience. A cet effet, les sons issus d'une capture sonore (par ex. au moyen des même microphones **5** que ceux employés pour la génération et le traitement du signal destiné au casque **7**) sont diffusés au moyen de haut-parleurs **17.**

Par conséquent, l'auditeur **2** est exposé (à travers son casque **7**) à un bruit ambiant dont la pression acoustique résulte de la propagation des sons naturels en champ libre et de la diffusion issue de la sonorisation générale via les haut-parleurs **17.**

Si l'auditeur **2** est assez éloigné de la scène, la pression acoustique du bruit ambiant peut être composée, pour l'essentiel, de la diffusion par haut-parleurs **17** (lesquels peuvent être disséminés autour de l'audience ou parmi elle, et qui, en outre, procurent une amplification du signal acoustique recomposé à partir des sons capturés).

Par conséquent, l'auditeur **2** perçoit deux signaux acoustiques :
- Un signal mixé issu de de la console **9** et diffusé dans son casque **7** ;
- Le bruit ambiant pénétrant dans son casque **7.**

On comprend alors que la somme de ces deux signaux puisse nuire au confort d'écoute de l'auditeur **2.** En particulier, il se peut que la somme des signaux exerce sur l'auditeur **2** un niveau de pression acoustique supérieur à son niveau de confort, voire même à son seuil de douleur.

Le bruit ambiant qui environne l'auditeur **2** à l'extérieur de son casque **7** ne peut pas être atténué. En revanche, le bruit ambiant pénétrant dans le casque **7** peut être atténué.

L'atténuation peut être procurée au moins en partie par des coussinets du casque **7** entourant les oreilles de l'auditeur **2,** qui sont avantageusement garnis d'une mousse ayant des propriétés d'isolation phonique.

L'atténuation peut en outre être procurée ou améliorée par un système de réduction actif des bruits (Active Noise Réduction ou ANR) dont est avantageusement équipé le casque **7.** Ce système de réduction des bruits comprend un microphone **18,** intégré au casque **7,** qui capture le bruit ambiant, et une électronique de contrôle (également intégrée au casque **7**) qui analyse le bruit ainsi capturé pour en estimer le niveau, et génère un contre-bruit en opposition de phase du bruit ambiant. Le contre-bruit est alors diffusé en temps réel dans le casque **7,** ce qui atténue le bruit ambiant dans celui-ci.

Cependant, même ainsi atténué, le bruit ambiant peut, en s'ajoutant au signal mixé issu de la console **9,** nuire au confort d'écoute de l'auditeur **2.**

C'est pourquoi il est prévu, après la phase **400** de mixage, une phase **500** de posttraitement, qui comprend :
∘ Une opération **510** de mesure du niveau sonore du bruit ambiant pénétrant dans le casque **7** ;
∘ Une opération **520** de correction globale du signal **16** audio mixé en fonction du niveau sonore du bruit ambiant.

La phase **500** de post-traitement est réalisée par l'appareil **14,** auquel est communiqué le signal **16** audio mixé (et plus précisément, dans l'exemple illustré, les signaux **16G, 16D** audios mixés gauche et droite).

Plus précisément, dans cette phase **500** de posttraitement :
o Le seuil de douleur pour l'auditeur **2** est pris en compte ou déterminé ;
o Le signal **16** audio mixé est corrigé de manière que le niveau sonore global dans le casque **7,** comprenant le signal audio mixé et le bruit ambiant pénétrant dans le casque **7,** soit à tout instant inférieur au seuil de douleur de l'auditeur **2.**

Si les caractéristiques de perception auditives mémorisées pour l'auditeur **2** incluent son seuil de douleur, celui-ci est simplement pris en compte. Si le seuil de douleur n'a pas été mémorisé, mais que le niveau de confort auditif l'a été, le seuil de douleur peut être déterminé par calcul à partir du niveau de confort, par ex. par ajout d'un gain prédéterminé (typiquement de 10 dB).

On observera que le signal **16** audio mixé (issu de la console **9**) et le bruit ambiant, qui résultent tous deux de la (ou des) même(s) source(s) **4** sonore(s), ne sont pas synchrones. En effet, le signal **16** audio mixé parvient à l'auditeur **2** à la vitesse électronique (grossièrement proche de la vitesse de la lumière), tandis que le bruit ambiant lui parvient à la vitesse sonique, qui est très inférieure à la vitesse électronique.

Même en tenant compte des traitements du signal appliqués par le système **1** de sonorisation, le signal **16** audio mixé est en avance sur le bruit ambiant. Il est donc nécessaire de les synchroniser pour que l'auditeur **2** n'ait pas d'écho lors de l'audition.

C'est pourquoi la phase **500** de post-traitement inclut de préférence une opération **530** de retardement appliqué au signal **16** audio mixé. Cette opération est conduite par l'appareil **14,** qui est à cet effet équipé d'une ligne à retard (matérielle ou logicielle). A cet effet, une corrélation est effectuée entre le signal **16** audio mixé et le bruit ambiant, pour estimer le délai entre eux (opération **540**) et le signal **16** audio mixé est retardé pour être recalé sur le bruit ambiant.

On notera que l'opération **530** de retardement précède l'opération **520** de correction globale.

Comme un réglage d'égalisation peut être commandé par l'auditeur, il est par ailleurs avantageux de n'appliquer l'opération **520** de correction globale qu'après la prise en compte d'un éventuel réglage **550** d'égalisation.

Dans l'exemple illustré, où la console **9** produit un signal **16G** audio mixé gauche et un signal **16D** audio mixé droit, la phase **500** de posttraitement est appliquée à chacun de ces signaux **16G, 16D** pour produire un signal **8G** audio conditionné (issu du posttraitement) gauche et un signal **8D** audio conditionné droit.

Comme illustré sur la **FIG.6****,** l'appareil **14** est équipé par sécurité d'une fonction **560** de réglage général manuel du niveau, réservé à l'auditeur **2,** qui peut être appliqué globalement au signal **8** conditionné, éventuellement avec une séparation pour le signal **8G** conditionné gauche, et pour le signal **8D** conditionné droite, et qui détermine le volume sonore de l'écoute.

Cette phase **500** de posttraitement est suivie (éventuellement après amplification **570,** comme illustré sur la **FIG.6**), d'une phase **600** de restitution, dans le casque **7,** du signal 8 audio conditionné posttraité (ici gauche et droite).

Le procédé de sonorisation qui vient d'être décrit permet par conséquent aux personnes souffrant de perte auditive de retrouver un confort d'audition lors de l'écoute de musique diffusée en live, non seulement en dépit de sa perte auditive mais également et tenant compte de ses caractéristiques de perception auditive.

Chaque auditeur **2** ayant ses caractéristiques de perception auditive propres, il bénéficie d'une écoute personnalisée. On voit que l'impact du bruit ambiant, dont il est tenu compte, peut être atténué. Il est à noter cependant qu'il n'est pas forcément souhaitable de supprimer totalement le bruit ambiant, qui peut procurer à un auditeur **2** habitué à l'isolement la sensation d'être cette fois pleinement intégré à une audience.

## Revendications

1. Procédé de sonorisation pour la diffusion en live, dans au moins un haut-parleur (**7G, 7D**) équipant un casque (**7**) porté ou destiné à être porté par un auditeur (**2**), d'un signal (**8**) audio conditionné à partir d'une pluralité de canaux (**6**) audio bruts, comprenant :
- Une phase (**100**) de prétraitement comprenant les opérations consistant à :
o Prendre en compte des caractéristiques de perception auditive de l'auditeur (**2**) ;
o Corriger chaque canal (**6**) en fonction des caractéristiques de perception auditive de l'auditeur (**2**) ;
- Une phase (**400**) de mixage comprenant l'élaboration, à partir des canaux (**6**) ainsi prétraités, d'un signal (**16**) audio mixé ;
- Une phase (**500**) de posttraitement comprenant les opérations consistant à :
o Mesurer (**510**) le niveau sonore d'un bruit ambiant pénétrant dans le casque (**7**) ;
o Corriger (**520**) le signal (**16**) audio mixé en fonction du niveau sonore du bruit ambiant ;
- Une phase (**600**) de restitution, dans le casque (**7**), du signal (**8**) audio conditionné issu du posttraitement ;
ledit procédé étant **caractérisé en ce que**,
dans la phase (**100**) de prétraitement, la prise en compte des caractéristiques de perception auditive de l'auditeur (**2**) comprend la prise en compte ou la détermination d'un niveau de confort auditif ; et
dans la phase (**100**) de prétraitement, la correction de chaque canal (**6**) consiste à le ramener sensiblement au niveau de confort auditif de l'auditeur (**2**).

2. Procédé selon la revendication 1, **caractérisé en ce que** la correction appliquée à chaque canal (**6**) comprend une correction en fréquence.

3. Procédé selon la revendication 1 ou la revendication 2, **caractérisé en ce que** la correction appliquée à chaque canal (**6**) comprend une correction temporelle.

4. Procédé selon l'une des revendications précédentes, **caractérisé en ce que** la correction appliquée à chaque canal (**6**) comprend une correction de niveau.

5. Procédé selon l'une des revendications précédentes, **caractérisé en ce que** la correction appliquée à chaque canal (**6**) comprend un ou plusieurs traitements choisis parmi un écrêtage, une compression, un gain.

6. Procédé selon l'une des revendications précédentes, **caractérisé en ce que** la phase (**100**) de prétraitement comprend les opérations consistant à :
o Echantillonner chaque canal (**6**) en fréquence,
o Sélectionner sur le canal (**6**) une ou plusieurs gammes de fréquences ;
o Appliquer au canal (**6**) un traitement dans la ou les gammes de fréquence sélectionnées, en fonction des caractéristiques de perception auditive de l'auditeur (**2**) dans cette ou ces gammes de fréquence.

7. Procédé selon l'une des revendications précédentes, **caractérisé en ce qu'**il comprend, entre la phase (**100**) de prétraitement et la phase (**400**) de mixage, une opération (**200**) de traitement panoramique pour constituer, à partir de chaque canal prétraité, une piste (**12G**) gauche et une piste (**12D**) droite.

8. Procédé selon la revendication 7, **caractérisé en ce qu'**il comprend, entre le traitement (**200**) panoramique et la phase (**400**) de mixage, une opération (**300**) d'amplification des pistes (**12G**) gauches et des pistes (**12D**) droites issues de chaque canal (**6**).

9. Procédé selon la revendication 8, **caractérisé en ce que** la phase (**400**) de mixage est conduite indépendamment pour les pistes (**12G**) gauches et pour les pistes (**12D**) droites, de sorte à élaborer un signal (**16G**) audio mixé gauche et un signal (**16D**) audio mixé droit.

10. Procédé selon la revendication 9, **caractérisé en ce que** la phase (**500**) de posttraitement est appliquée au signal (**16G**) audio mixé gauche et au signal (**16D**) audio mixé droit pour produire un signal (**8D**) audio conditionné gauche et un signal (**8D**) audio conditionné droit.

11. Procédé selon l'une des revendications précédentes, **caractérisé en ce que**, dans la phase (**500**) de post-traitement, la mesure (**510**) du niveau sonore du bruit environnant le casque (**7**) est effectuée au moyen d'un microphone (**18**) intégré au casque (**7**).

12. Procédé selon l'une des revendications précédentes, **caractérisé en ce que**, dans la phase de posttraitement :
o Un seuil de douleur pour l'auditeur (**2**) est pris en compte ou déterminé ;
o Le signal (**16**) audio mixé est corrigé de manière que le niveau sonore global dans le casque (**7**), comprenant le signal (**8**) audio mixé et le bruit ambiant pénétrant dans le casque (**7**), soit à tout instant inférieur au seuil de douleur de l'auditeur (**2**).

13. Procédé selon l'une des revendications précédentes, **caractérisé en ce que** la phase (**500**) de posttraitement comprend l'application d'un retard (**530**) au signal (**16**) audio mixé pour le recaler sur le bruit ambiant mesuré, préalablement à sa correction.

## Patentansprüche

1. Beschallungsverfahren für das Live-Übertragen eines Audiosignals (8), das aus einer Vielzahl von Raw-Audiokanälen (6) aufbereitet wurde, in mindestens einem Lautsprecher (7G, 7D), mit dem ein Kopfhörer (7) ausgestattet ist, der von einem Zuhörer (2) getragen wird oder getragen werden soll, umfassend:
- eine Vorverarbeitungsphase (100), die die Schritte umfasst, die aus Folgendem bestehen:
o Berücksichtigen der Eigenschaften der auditiven Wahrnehmung des Zuhörers (2);
o Korrigieren jedes Kanals (6) als Funktion der Eigenschaften der auditiven Wahrnehmung des Zuhörers (2);
- eine Mischphase (400), die das Erzeugen eines gemischten Audiosignals (16) aus den so vorverarbeiteten Kanälen (6) umfasst;
- eine Nachbearbeitungsphase (500), die die Schritte umfasst, die aus Folgendem bestehen:
o Messen (510) des Schallpegels eines in den Kopfhörer (7) eindringenden Hintergrundlärms;
o Korrigieren (520) des gemischten Audiosignals (16) als Funktion des Schallpegels des Hintergrundlärms;
- eine Phase (600) der Wiedergabe des aufbereiteten Audiosignals (8), das aus der Nachbearbeitung resultiert, im Kopfhörer (7);
wobei das Verfahren **dadurch gekennzeichnet ist, dass** das Berücksichtigen der Eigenschaften der auditiven Wahrnehmung des Zuhörers (2) in der Vorverarbeitungsphase (100) das Berücksichtigen oder das Bestimmen eines Pegels an Hörkomfort umfasst; und das Korrigieren jedes Kanals (6) in der Vorverarbeitungsphase (100) darin besteht, diesen im Wesentlichen auf den Pegel an Hörkomfort des Zuhörers (2) zu bringen.

2. Verfahren nach Anspruch 1, **dadurch gekennzeichnet, dass** die auf jeden Kanal (6) angewendete Korrektur eine Frequenzkorrektur umfasst.

3. Verfahren nach Anspruch 1 oder Anspruch 2, **dadurch gekennzeichnet, dass** die auf jeden Kanal (6) angewendete Korrektur eine Zeitkorrektur umfasst.

4. Verfahren nach einem der vorhergehenden Ansprüche, wobei die auf jeden Kanal angewendete (6) Korrektur eine Pegelkorrektur umfasst.

5. Verfahren nach einem der vorhergehenden Ansprüche, **dadurch gekennzeichnet, dass** die auf jeden Kanal (6) angewendete Korrektur eine oder mehrere Verarbeitungen umfasst, die aus einem Clipping, einer Komprimierung und einer Verstärkung ausgewählt werden.

6. Verfahren nach einem der vorhergehenden Ansprüche, **dadurch gekennzeichnet, dass** die Vorverarbeitungsphase (100) die Schritte umfasst, die aus Folgendem bestehen:
o Abtasten der Frequenz jedes Kanals (6),
o Auswählen eines oder mehrerer Frequenzbereiche in dem Kanal (6);
o Anwenden einer Verarbeitung im ausgewählten Frequenzbereich bzw. in den ausgewählten Frequenzbereichen auf den Kanal (6) als Funktion der Eigenschaften der auditiven Wahrnehmung des Zuhörers (2) in diesem Frequenzbereich bzw. diesen Frequenzbereichen.

7. Verfahren nach einem der vorhergehenden Ansprüche, **dadurch gekennzeichnet, dass** es zwischen der Vorverarbeitungsphase (100) und der Mischphase (400) einen Panoramaverarbeitungsschritt (200) umfasst, um aus jedem vorverarbeiteten Kanal eine linke Spur (12G) und eine rechte Spur (12D) zu bilden.

8. Verfahren nach Anspruch 7, **dadurch gekennzeichnet, dass** es zwischen der Panoramaverarbeitung (200) und der Mischphase (400) einen Verstärkungsschritt (300) der linken Spuren (12G) und der rechten Spuren (12D) aus jedem Kanal (6) umfasst.

9. Verfahren nach Anspruch 8, **dadurch gekennzeichnet, dass** die Mischphase (400) unabhängig für die linken Spuren (12G) und für die rechten Spuren (12D) durchgeführt wird, so dass ein linkes gemischtes Audiosignal (16G) und ein rechtes gemischtes Audiosignal (16D) erzeugt werden.

10. Verfahren nach Anspruch 9, **dadurch gekennzeichnet, dass** die Nachbearbeitungsphase (500) auf das linke gemischte Audiosignal (16G) und das rechte gemischte Audiosignal (16D) angewendet wird, um ein linkes aufbereitetes Audiosignal (8D) und ein rechtes aufbereitetes Audiosignal (8D) zu produzieren.

11. Verfahren nach einem der vorhergehenden Ansprüche, **dadurch gekennzeichnet, dass** in der Nachbearbeitungsphase (500) das Messen (510) des Schallpegels des den Kopfhörer (7) umgebenden Lärms mittels eines in den Kopfhörer (7) integrierten Mikrofons (18) ausgeführt wird.

12. Verfahren nach einem der vorhergehenden Ansprüche, **dadurch gekennzeichnet, dass** in der Nachbearbeitungsphase:
o eine Schmerzgrenze für den Zuhörer (2) berücksichtigt oder bestimmt wird;
o das gemischte Audiosignal (16) derart korrigiert wird, dass der globale Schallpegel im Kopfhörer (7), umfassend das gemischte Audiosignal (8) und den in den Kopfhörer (7) eindringenden Hintergrundlärm, zu jedem Zeitpunkt geringer ist als die Schmerzgrenze des Zuhörers (2).

13. Verfahren nach einem der vorhergehenden Ansprüche, **dadurch gekennzeichnet, dass** die Nachbearbeitungsphase (500) das Anwenden einer Verzögerung (530) auf das gemischte Audiosignal (16) umfasst, um es vor seiner Korrektur an den gemessenen Hintergrundlärm anzupassen.

## Claims

1. A public address method for live broadcast, in at least one loudspeaker (**7G, 7D**) equipping a headset (**7**) worn or intended to be worn by a listener (**2**), of an audio signal (**8**) conditioned from a plurality of raw audio channels (**6**), comprising:
- a pre-processing phase (**100**) comprising the operations of:
o taking into account characteristics of the auditory perception of the listener (**2**);
o correcting each channel (**6**) depending on the characteristics of the auditory perception of the listener (**2**);
- a mixing phase (**400**) comprising the production, from the channels (**6**) thus pre-processed, of a mixed audio signal (**16**);
- a post-processing phase (**500**) comprising the operations of:
o measuring (**510**) the sound level of a background noise penetrating the headset (**7**);
o correcting (**520**) the mixed audio signal (**16**) depending on the sound level of the background noise;
- a phase (**600**) of reproducing, in the headset (**7**), the conditioned audio signal (**8**) resulting from the post-processing;
said method being **characterised in that**, in the pre-processing phase (**100**), taking into account the characteristics of the auditory perception of the listener (**2**) comprises taking into account or determining a level of auditory comfort; and in the pre-processing phase (**100**), correcting each channel (**6**) consists in bringing it substantially back to the level of auditory comfort of the listener (**2**).

2. The method according to claim 1, **characterised in that** the correction applied to each channel (**6**) comprises a frequency correction.

3. The method according to claim 1 or claim 2, **characterised in that** the correction applied to each channel (**6**) comprises a time correction.

4. The method according to one of the preceding claims, **characterised in that** the correction applied to each channel (**6**) comprises a level correction.

5. The method according to one of the preceding claims, **characterised in that** the correction applied to each channel (**6**) comprises one or more processing selected from clipping, compression, gain.

6. The method according to one of the preceding claims, **characterised in that** the pre-processing phase (**100**) comprises the operations of:
o frequency sampling each channel (**6**),
o selecting, on the channel (6), one or more frequency ranges;
o applying a processing, in the selected frequency range(s), to the channel (**6**), depending on the characteristics of the auditory perception of the listener (2) in this or these frequency ranges.

7. The method according to one of the preceding claims, **characterised in that** it comprises, between the pre-processing phase (**100**) and the mixing phase (**400**), a panoramic processing operation (**200**) to constitute, from each pre-processed channel, a left track (**12G**) and a right track (**12D**).

8. The method according to claim 7, **characterised in that** it comprises, between the panoramic processing (**200**) and the mixing phase (**400**), an operation (**300**) of amplifying the left tracks (**12G**) and the right tracks (**12D**) from each channel (6).

9. The method according to claim 8, **characterised in that** the mixing phase (**400**) is conducted independently for the left tracks (**12G**) and for the right tracks (**12D**), so as to produce a left mixed audio signal (**16G**) and a right mixed audio signal (**16D**).

10. The method according to claim 9, **characterised in that** the post-processing phase (**500**) is applied to the left mixed audio signal (16G) and to the right mixed audio signal (**16D**) to produce a left conditioned audio signal (**8D**) and a right conditioned audio signal (**8D**).

11. The method according to one of the preceding claims, **characterised in that**, in the post-processing phase (**500**), the measurement (**510**) of the sound level of the noise surrounding the headset (**7**) is performed by means of a microphone (**18**) integrated into the headset (**7**).

12. The method according to one of the preceding claims, **characterised in that**, in the post-processing phase:
o a pain threshold for the listener (**2**) is taken into account or determined;
o the mixed audio signal (**16**) is corrected so that the overall sound level in the headset (**7**), comprising the mixed audio signal (**8**) and the background noise penetrating the headset (**7**), is at all times lower than the pain threshold of the listener (**2**).

13. The method according to one of the preceding claims, **characterised in that** the post-processing phase (**500**) comprises the application of a delay (**530**) to the mixed audio signal (**16**) to recalibrate it to the measured background noise, prior to the correction thereof.
